# EUROPEAN PATENT APPLICATION

(11) **EP 0 690 511 A1**
(43) Date of publication of application: **03.01.1996**
(21) Application number: 95104811.5
(22) Date of filing: 31.03.1995
(51) Int. Cl.: H01L 29/10

(54) **Compound semiconductor device and its manufacturing method**

(30) Priority: 30.06.1994 JP 150131/94
(71) Applicant: FUJITSU LIMITED, Kawasaki-shi, Kanagawa 211 (JP)
(72) Inventor: Sano, Seigo, c/o Fujitsu Quantum Devices Ltd., Nakakoma-gun, Yamanashi, 409-38 (JP); Ebrahim, Heidarpour A., c/o Fujitsu Quantum, Nakakoma-gun, Yamanashi, 409-38 (JP)
(74) Representative: Seeger, Wolfgang, Dipl.-Phys.

(57) **Abstract**

A compound semiconductor device according to the present invention has a first GaAs layer (2), on a semiconductor substrate (1) made of GaAs or silicon, excessively including arsenic formed at a growing temperature equal to or less than 300 °C. On the first GaAs layer (2), a group III-V compound semiconductor layer (4,5) including In formed at a high temperature equal to or more than 500 °C is provided through a second GaAs layer (3), which is for the purpose of absorbing a growing temperature change. On the In containing group III-V compound semiconductor layer (5), a third GaAs layer (6) is formed at a growing temperature equal to or more than 500 °C, and then, an active layer (7) for forming a transistor region is formed. In this growing process, the arsenic excessively included in the first GaAs layer (2) precipitates to form a high resistance layer. Also, the diffusion of the excessive arsenic to the active layer (7) is prevented by the group III-V compound semiconductor layer (5) including In. As a result, the compound semiconductor device having a high break-down voltage and high frequency characteristics is obtained.

## Description

### BACKGROUND OF THE INVENTION

### 1. Field of the invention:

The present invention relates generally to a compound semiconductor device and its manufacturing method, and more particularly to a compound semiconductor device having a field effect transistor (FET) and its manufacturing method.

### 2. Description of the prior art

A power FET utilized as a microwave device for a satellite communication or a mobile phone is required to be used at a high frequency, to be used for a long time, to be used at a high electric power efficiency and to be downsized. By considering the above requests, various types of compound semiconductor field effect transistors have been manufactured, and a GaAs metal-semiconductor (MES) FET is well-known as one of the FETs.

To avoid a back gate effect or a side gate effect occurring through a semi-insulating GaAs substrate in the GaAs MESFET, the utilization of a low temperature buffer (LTB) GaAs layer is reported in the following literature (1).
(1) F.W. Smith et al., IEEE Electron Device Lett. Vol.9, No.2, pp.77-80, 1988.

The LTB GaAs layer grows at a low temperature ranging from 200 to 300 °C according to a molecular beam epitaxy (MBE) method, and the LTB GaAs layer is annealed to obtain a high resistance on the order of 10⁶ Ωcm. The reason that the LTB GaAs layer has the high resistance is because of arsenic (As) about 1.5 atomic % in excess of the stoichiometric value. The excessive arsenic exists as arsenic coagulating grains because of the annealing at a high temperature.

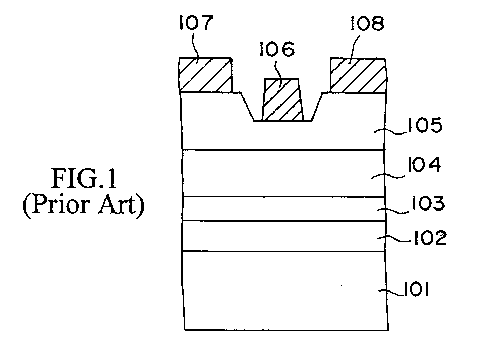

A MESFET having the LTB GaAs layer is, for example, formed in a cross sectional structure shown in Fig. 1, and an LTB GaAs layer 102 having an excessive arsenic, a temperature absorbing GaAs layer 103 and a un-doped GaAs layer 104 are formed on a semi-insulating GaAs substrate 101 in that order. An n type GaAs channel layer 105 is formed on the un-doped GaAs layer 104. A gate electrode 106 of the MESFET is formed on the GaAs channel layer 105 in Schottky-contact, and a source electrode 107 and a drain electrode 108 of the MESFET are respectively formed on the GaAs channel layer 105 in ohmic contact and are placed at both sides of the gate electrode 106. Therefore, the MESFET can be manufactured to have a high break-down voltage because of the existence of the LTB GaAs layer 102.

Here, a device in which an AlGaAs layer is formed in place of the un-doped GaAs layer 104 is also proposed.

The GaAs channel layer 105 is formed in an epitaxial growth at a temperature of about 600 °C, and crystal defects of the LTB GaAs layer 102 spread to the GaAs channel layer 105 under the influence of the heat occurring at the time of the layer growth. The defects degrade the crystallization of the GaAs channel layer 105, so that there is a drawback that high frequency wave output characteristics and efficiency in the MESFET are degraded.

In general, the higher an output power of a compound semiconductor electronic device, the larger an electric power of the device. An electric power other than that of taken out as a high frequency power is released to the outside as heat. For example, 50% of an applied electric power is released as heat in case of an A-grade operation. Therefore, the electronic device is required to efficiently release the heat into outside for the purpose of enhancing the characteristics of the electronic device and lengthening a life of the electronic device. In this case, because a thermal conductivity of GaAs is low, there is a case that a silicon substrate is used in place of the GaAs substrate to form the GaAs layer on the silicon substrate.

However, when the GaAs layer is formed on the silicon substrate, crystal defects are generated in the GaAs layer because of the difference in lattice constants between the silicon layer and the GaAs layer. The drawback of the defects is, for example, disclosed in a Published Unexamined Japanese Patent Application No. 70715 of 1986 and another Published Unexamined Japanese Patent Application No. 36717 of 1991. When the defects are generated in the GaAs layer, the break-down voltage decreases under the influence of the crystal defects, thus causing the degradation of high frequency characteristics such as a high frequency output power, a linearity, an efficiency and the like.

### SUMMARY OF THE INVENTION

An object of the present invention is to provide, with due consideration to the above drawbacks, a compound semiconductor device in which high frequency characteristics of an electronic device such as a high frequency output, a linearity, an efficiency and the like are improved.

According to the present invention, on a first buffer layer comprising gallium arsenide (GaAs) in which an arsenic content is higher than a gallium content, a second buffer layer comprising a group III-V compound semiconductor in which indium is included is formed, and an active layer is formed on the second buffer layer.

Inventors of the present invention confirm that, in the above structure, the amount of arsenic diffused from the first buffer layer is reduced, and therefore, high frequency characteristics of an electronic device such as a high frequency output power, a linearity, an efficiency and the like are improved. Arsenic diffused from the first buffer layer produces trap levels ranging from 0.3 to 0.4 eV in the active layer. When the second buffer layer is formed on the first buffer layer, there is an effect that a density peak of the trap levels ranging from 0.3 to 0.4 eV in the active layer is reduced.

In case where the first buffer layer comprises gallium arsenide (GaAs), it is preferred that indium-gallium-arsenic (InGaAs) be used as a material of the second buffer layer. It is also preferred that a composition ratio (mole fraction) of indium against gallium be equal to or more than 0.3 because the effect is heightened. It is also preferred that a thickness of the InGaAs be equal to or less than 100 Å in view of a critical film thickness. The reason is that crystal defects are generated in the InGaAs layer in case where the thickness of the InGaAs layer is more than its critical film thickness.

Also, in case where the InGaAs layer and the GaAs layer are alternately formed on the GaAs layer (that is, the first buffer layer) excessively having the arsenic to form a plurality of alternated layers, the trap levels ranging from 0.3 to 0.4 eV are moreover reduced. Therefore, it is preferred to adopt the above configuration.

A substrate on which the GaAs layer excessively having the arsenic is formed is not limited to GaAs, and it is applicable that silicon be adopted as the substrate. A heat dissipation effect in the silicon substrate is superior to that in the GaAs. Even though the substrate is formed of silicon, a high resistance layer is obtained by the GaAs layer excessively having the arsenic on the silicon substrate. Therefore, the degradation of the break-down voltage is suppressed. As a result, the high frequency characteristics can be improved. The first buffer layer excessively having the arsenic is formed at a growing temperature equal to or less than 300 °C.

### BRIEF DESCRIPTION OF THE DRAWINGS

Fig. 1 is a cross sectional view of a conventional MESFET;
Figs. 2A and 2B are cross sectional views showing a manufacturing method of a MESFET according to a first embodiment of the present invention;
Fig. 3 is a characteristic graph showing a high frequency output power and a drain current efficiency with respect to a high frequency input power for the conventional MESFET and the MESFET according to the first embodiment;
Fig. 4 is a transistor characteristic graph showing a relationship between a drain-source differential voltage and a drain current in the MESFET according to the first embodiment;
Fig. 5 is a transistor characteristic graph showing a relationship between a drain-source differential voltage and a drain current in the conventional MESFET;
Fig. 6 is a graph showing a relationship between a trap level density in an active layer and a temperature for the conventional MESFET and the MESFET according to the first embodiment of the present invention;
Fig. 7 is a graph showing a relationship between a depth of the active layer and a density of traps whose energy levels range from 0.3 to 0.2 eV for the conventional MESFET and the MESFET according to the first embodiment of the present invention;
Fig. 8 is a characteristic view showing a relationship between an In composition ratio in an InGaAs layer of the MESFET according to the first embodiment of the present invention and a density of traps whose energy levels range from 0.3 to 0.4 eV and another relationship between the In composition ratio in the InGaAs layer and a high frequency output power;
Fig. 9 is a cross sectional view showing a high electron mobility transistor (HEMT) according to a second embodiment of the present invention;
Fig. 10 is a cross sectional view showing a MESFET according to a third embodiment of the present invention;
Fig. 11 is a transistor characteristic graph showing a relationship between a drain-source differential voltage and a drain current in the MESFET according to the third embodiment of the present invention;
Fig. 12 is a transistor characteristic graph showing a relationship between a drain-source differential voltage and a drain current in a conventional MESFET directly formed on a silicon substrate without having any InGaAs layer therebetween; and
Fig. 13 is a cross sectional view showing a MESFET according to a fourth embodiment of the present invention.

### DETAILED DESCRIPTION OF THE EMBODIMENTS

Hereinafter, embodiments of the present invention are described with referring to drawings.

### (A first embodiment)

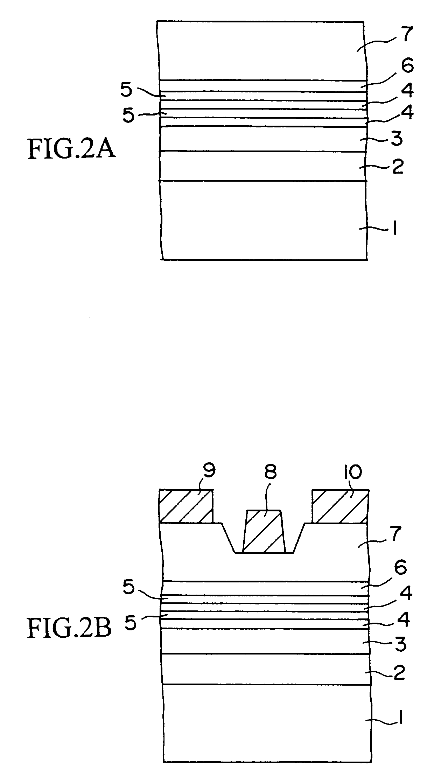

Figs. 2A and 2B are cross sectional views showing a manufacturing method of a MESFET according to a first embodiment of the present invention.

In Fig. 2A, on a semi-insulating GaAs (compound semiconductor) substrate 1 having a thickness of 600 µm, a low temperature buffer GaAs layer (LTB GaAs layer) 2 grows at a temperature ranging from 200 to 300 °C in a thickness of 2000 Å. In the LTB GaAs layer 2, a content of arsenic is higher than that of gallium. To this end, the ratio (mole fraction) of the radiation amount of As to that of Ga is, for example, set to be 5:1, in a molecular beam epitaxy method.

Thereafter, a growing temperature is increased up to 540 °C. However, in case where the growing temperature quickly increases from 300 °C to 540 °C, a distortion occurs in a growing layer under the influence of the thermal change of the growing temperature. Therefore, a GaAs layer 3 is formed in a thickness of 500 Å on the LTB GaAs layer 2 in a process in which the growing temperature gradually and successively increases, and an inverse influence based on the quick temperature change is prevented. That is, the GaAs layer 3 is formed to absorb the temperature change. In this case, the arsenic excessively included in the LTB GaAs layer 2 precipitates to form coagulating grains while the growing temperature is increased, and the arsenic coagulating grains are set in a Schottky-contact condition with GaAs surrounding the arsenic coagulating grains. As a result, a resistance of the LTB GaAs layer 2 is set on the order of 10¹⁶ Ωcm.

In addition, a GaAs layer 4 and an In_{y}Ga_{1-y}As distorted layer 5 alternately grow on the temperature absorbing GaAs layer 3 to form a plurality of alternated layers. Each of the GaAs layers 4 and the In_{y}Ga_{1-y}As distorted layers 5 has a thickness of 50 Å. The alternated layers, for example, grow at a temperature of 538 °C. In this case, it is preferred that a composition ratio y in the In_{y}Ga_{1-y}As be equal to or more than 0.3. Also, any impurity is not doped into the growing layers.

Thereafter, an un-doped or p-type GaAs layer 6 is formed on the In_{y}Ga_{1-y}As distorted layer 5 at a temperature of about 600 °C in a thickness of about 100 Å. Subsequently, an n-type GaAs channel layer (an active layer) 7 having a silicon content of 1.5 × 10¹⁷ cm⁻³ is formed at a thickness of 3000 Å. In this structure, a buffer layer is composed of layers ranging from the GaAs layer 2 having excess arsenic to the GaAs layer 6.

Thereafter, as shown in Fig. 2B, a recess structure is formed by etching the GaAs channel layer 7 placed at a gate region by 1500 Å. Subsequently, a gate electrode 8 is formed on the recess portion of the GaAs channel layer 7. In addition, a source electrode 9 and a drain electrode 10 are formed on two convex portions of the GaAs channel layer 7. The gate electrode 8 is, for example, made of tungsten silicide (WSi) and is set in Schottky-contact with the channel layer 7. Also, the source electrode 9 and drain electrode 10 are made of AuGe/Au and are set in ohmic-contact with the channel layer 7. A width (a gate length) of the gate electrode 8 in a channel length direction is, for example, 1 µm.

It is applicable that the GaAs channel layer 7 be not formed in the recess structure to form the gate electrode 8, the source electrode 9 and the drain electrode 10 on the same plane. Also, at least one In_{y}Ga_{1-y}As layer 5 is sufficient in the buffer layer. In this case, it is required to set a thickness of the In_{y}Ga_{1-y}As layer 5 equal to or less than a critical film thickness for the purpose of preventing the occurrence of crystal defects. In case where the composition ratio y is equal to or more than 0.3, it is preferred that the In_{y}Ga_{1-y}As layer 5 be set in a thickness equal to or less than 100 Å to suppress the occurrence of crystal defects.

The above MESFET is formed according to a molecular beam epitaxy (MBE) method, a molecular organic vapor phase epitaxy (MOVPE) method, a gas source MBE (GSMBE) method or the like. (These methods are also used in following embodiments in the similar manner).

In the above configuration of the MESFET, the GaAs layer 4 and the In_{y}Ga_{1-y}As layer 5 respectively having a film thickness of 50 Å alternately grow by repeating four times, and characteristics such as a high frequency output, an efficiency and the like are analyzed in case of the composition ratio y=0.3. The characteristics are compared with those of a device in which the un-doped GaAs layer 104 shown in Fig. 1 is formed in a thickness of 500 Å as a buffer layer.

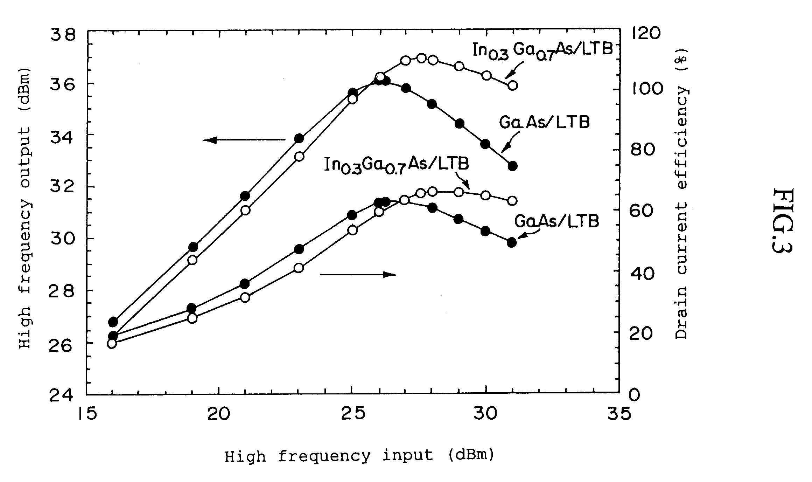

A high frequency output power and a drain current efficiency are initially examined, and the result is shown in Fig. 3. In the conventional device shown in Fig. 1 in which InGaAs is not formed on the LTB layer, the maximum peak of the high frequency output power reaches 36 dBm, and the maximum peak of the drain current efficiency reaches 61%. In contrast, in the device having the In_{y}Ga_{1-y}As layer 5 according to this embodiment, the maximum peak of the high frequency output power reaches 37 dBm, and the maximum peak of the drain current efficiency reaches 68%. Therefore, it is realized that those characteristics are improved in the device of this embodiment.

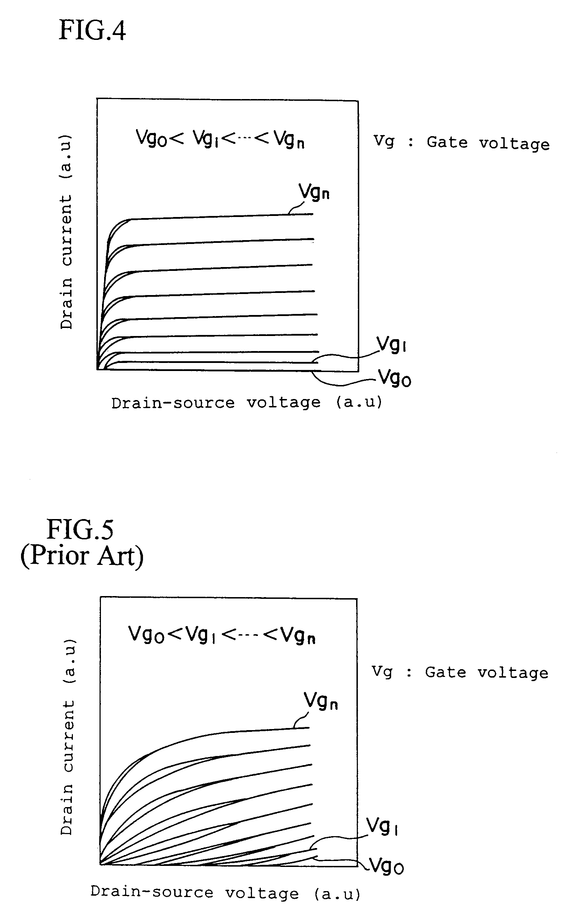

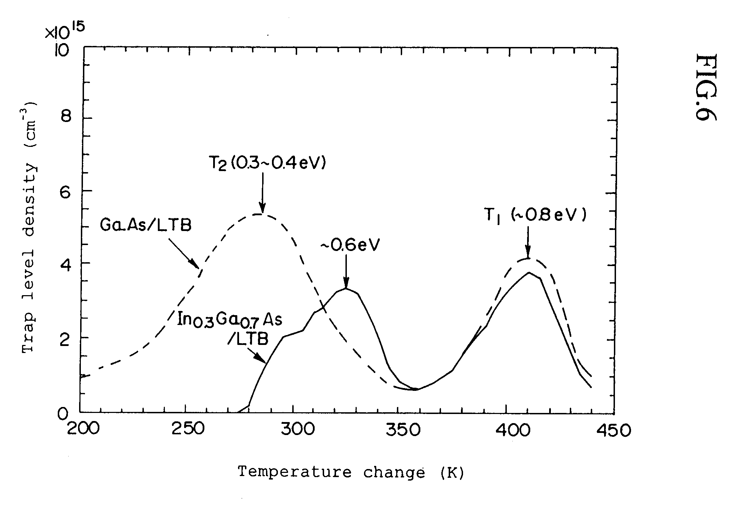

Also, in the conventional device having the configuration shown in Fig. 1 in which no In_{y}Ga_{1-y}As layer is formed on the LTB GaAs layer, as shown in Fig. 5, it is realized that a drain current with respect to a drain-source differential voltage is not easily saturated and a spouting current exists in a high voltage side. In contrast, in this embodiment, as shown in Fig. 4, it is realized that a drain current with respect to a drain-source differential voltage is easily saturated and a spouting current does not almost flow. Here, the spouting current denotes a current flowing through the buffer layer placed under the GaAs channel layer 7.

The reason why the spouting current is considerably reduced to improve the high frequency output power and the drain current efficiency will be described below.

Deep energy levels existing in each of the GaAs channel layers 7 and 105 are measured according to a deep level transient spectroscopy (DLTS) method, and the result shown in Fig. 6 is obtained. In the graph shown in Fig. 6, the axis of ordinates represents a trap level density and the axis of abscissas represents a substrate temperature at a measurement.

In case of the conventional device (Fig. 1) in which the GaAs layer free of In is initially formed on the LTB GaAs layer and the GaAs channel layer is formed on the GaAs layer, traps whose energy levels range from 0.3 to 0.4 eV show the maximum density value as shown in Fig. 6. In contrast, in this embodiment, as is shown by a solid line in Fig. 6, a density peak of trap levels exists at 0.6 eV, and the density of the trap levels ranging from 0.3 to 0.4 eV is considerably reduced as compared with that in the conventional device.

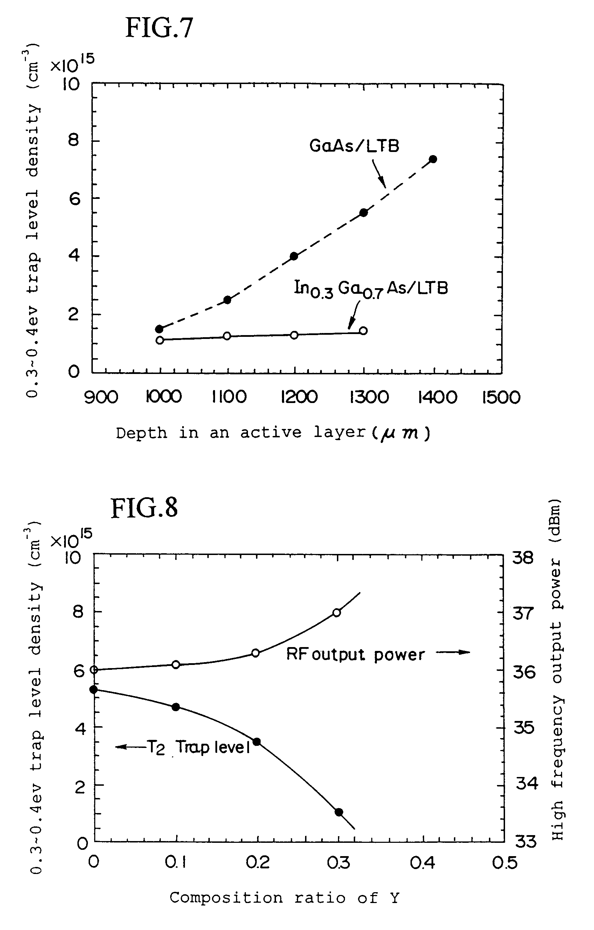

Also, characteristics of the trap level density ranging from 0.3 to 0.4 eV are examined. As is shown by a broken line in Fig. 7, in case of the conventional configuration in which In is not included in the buffer layer, the deeper the position of the trap levels in the channel layer, the larger the density of the trap levels. The density of the trap levels at the depth of 1300 µm in the channel layer reaches about 6 × 10¹⁵ cm⁻³. In contrast, in case of the configuration according to this embodiment in which In is included in the buffer layer, as is shown by a solid line in Fig. 7, it is realized that the density of the trap levels ranging from 0.3 to 0.4 eV is about 1 × 10¹⁵ cm⁻³ and is constant in no connection with the depth of the channel layer. However, such trap levels are not detected in a device in which any GaAs layer excessively having arsenic is not formed.

Also, the density of the trap levels ranging from 0.3 to 0.4 eV and the high frequency output power are examined in case where a value of the In composition ratio y in the In_{y}Ga_{1-y}As layer is changed, and the result shown in Fig. 8 is obtained. As is realized, the higher the In composition ration y, the lower the density of the trap levels, and the high frequency output power is improved. In particular, as for the high frequency output power, it is realized from a characteristic curve of the output power that the characteristics of the output power are apparently improved in case where the In composition ratio (mole fraction) y is equal to or more than 0.3.

Therefore, GaAs layer including In on the LTB GaAs layer 2 has an effect that the diffusion of the arsenic from the LTB GaAs layer 2 to the channel layer 7 is prevented, and the characteristics of the high frequency output power and the drain current efficiency are improved. In addition, in case where the GaAs layer 4 and the In_{y}Ga_{1-y}As layer 5 are alternately arranged to form a plurality of alternated layers, that is, a supper lattice structure, the effect for suppressing the diffusion of the arsenic becomes more remarkable. Therefore, it is preferred that the GaAs layer 4 and the In_{y}Ga_{1-y}As layer 5 be alternately arranged to form a plurality of alternated layers. In other words, by forming a supper lattice structure of the GaAs layer 4 and the InGaAs layer 5, the suppressing effect of arsenic is enhanced.

In addition, in Fig. 6, a density peak exists in trap levels of 0.8 eV, and this peak exists in no connection with the existence of the LTB GaAs layer. Therefore, it is realized that the density of the trap levels of 0.8 eV has no connection with the degradation of the high frequency characteristics and the efficiency resulting from the formation of the LTB GaAs layer in the electronic device.

### (A second embodiment)

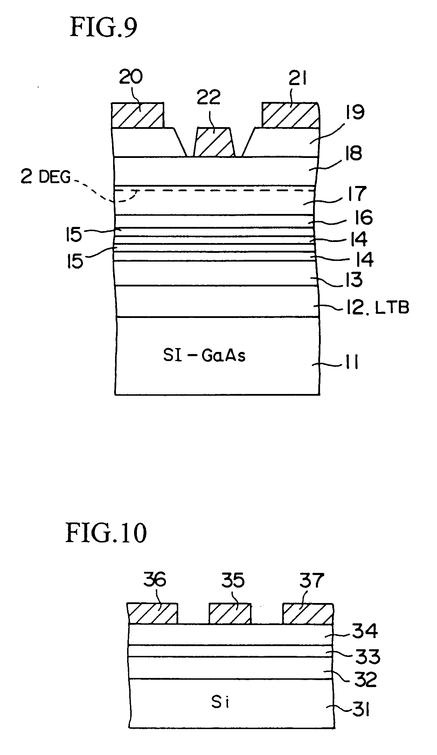

Fig. 9 is a cross sectional view showing a HEMT according to a second embodiment of the present invention. In the same manner as the first embodiment, the HEMT has an In_{y}Ga_{1-y}As layer formed between an LTB GaAs layer and a channel region.

In Fig. 9, on a semi-insulating GaAs substrate 11 having a thickness of 600 µm, an LTB GaAs layer 12 grows at a temperature ranging from 200 to 300 °C in a film thickness of 2000 Å. The LTB GaAs layer 12 grows on condition that a radiation amount of arsenic is five or more times that of gallium in, for example, a MBE method.

Thereafter, a growing temperature is increased up to 540 . In a temperature increasing process, a temperature absorbing GaAs layer 13 is formed in a thickness of 500 Å on the LTB GaAs layer 12. In this case, the arsenic excessively included in the LTB GaAs layer 12 precipitates to form coagulating grains while the growing temperature is increased, and a resistance of the LTB GaAs layer 12 is set on the order of 10¹⁶ Ωcm.

In addition, a GaAs layer 14 and an In_{y}Ga_{1-y}As distorted layer 15 alternately grow on the temperature absorbing GaAs layer 13 to form a plurality of alternated layers. Each of the GaAs layers 14 and the In_{y}Ga_{1-y}As distorted layers 15 has a thickness of 50 Å. The alternated layers, for example, grow at a temperature of 538 °C. In this case, it is preferred that a composition ratio y in the In_{y}Ga_{1-y}As be equal to or more than 0.3, in the same manner as in the first embodiment.

Thereafter, an un-doped GaAs layer 16 is formed on the In_{y}Ga_{1-y}As distorted layer 15 placed at the top at a temperature of about 600 °C in a thickness of about 100 Å, and an InGaAs active layer 17 is formed at a thickness of 1000 Å. A buffer layer is composed of layers ranging from the LTB GaAs layer 12 to the GaAs layer 16. Here, any impurity is not doped into the above growing layers. Subsequently, an n-type InAlAs electron supplying layer 18 having a thickness of 500 Å and an n-InGaAs cap layer 19 having a thickness of 1000 Å are formed on the active layer 17. In this case, silicon impurity concentrations of the n-InAlAs electron supplying layer 18 and the n-InGaAs cap layer 19 are set to 1 × 10¹⁸ cm⁻³ together. A two-dimensional electron gas (2DEG) is generated in the boundary between the active layer 17 and the electron supplying layer 18.

After the above lamination layer process for the compound semiconductor has been completed, the cap layer 19 placed at a gate region is removed by applying a resist process in a normal photo lithography technique to form a recess structure.

Thereafter, a source electrode 20 and a drain electrode 21 are formed on the cap layer 19 placed at both sides of the gate region. The source and drain electrodes 20, 21 are made of AuGe/Au.

Thereafter, an alloying process is performed to set the source electrode 20 and the drain electrode 21 in ohmic-contact with the 2DEG, and a gate electrode 22 made of WSi or the like is formed on the electron supplying layer 18 in a Schottky-contact condition. Thus, the production of the HEMT is completed.

In this embodiment, the In_{y}Ga_{1-y}As layers 14 exists between the active layer 17 and the LTB GaAs layer 12, in the same manner as in the first embodiment, and the diffusion of the arsenic excessively included in the LTB GaAs layer to the active layer 17 is prevented by the In_{y}Ga_{1-y}As layers 14. Therefore, the characteristics of the high frequency output power and the drain current efficiency are improved.

It is applicable that the cap layer 19 be not formed in the recess structure to form the gate electrode 22, the source electrode 20 and the drain electrode 21 on the same plane. Also, it is applicable that at least one In_{y}Ga_{1-y}As layer 15 exist between the active layer 17 and the LTB GaAs layer 12. In this case, a thickness of the In_{y}Ga_{1-y}As layer 15 is equal to or less than a critical film thickness for the purpose of preventing the occurrence of crystal defects.

### (A third embodiment)

Fig. 10 is a cross sectional view showing a MESFET according to a third embodiment of the present invention. In Fig. 10, an LTB GaAs layer 32 grows on an un-doped silicon substrate 31 at a temperature equal to or less than 200 °C in a film thickness of 2000 Å. In the LTB GaAs layer 32, a content of arsenic is higher than that of gallium. For example, the LTB GaAs layer 32 grows on condition that the arsenic radiation amount is five or more times the gallium radiation amount in a MBE method.

An un-doped In_{y}Ga_{1-y}As layer 33 is formed on the LTB GaAs layer 32. The In_{y}Ga_{1-y}As layer 33 grows while a growing temperature is increased from a low temperature of 200 °C or less to a temperature of almost 600 °C. A thickness of the In_{y}Ga_{1-y}As layer 33 is equal to or less than a critical film thickness, and the occurrence of crystal defects in semiconductor layers laminated on the layer 33 is suppressed. The arsenic excessively included in the LTB GaAs layer 32 precipitates to form coagulating grains under the influence of the growing temperature increased in case of the formation of the In_{y}Ga_{1-y}As layer 33, and the LTB GaAs layer 32 has a high resistance. In this case, it is preferred that a composition ratio y in the In_{y}Ga_{1-y}As be equal to or more than 0.2. Also, a buffer layer is composed of the LTB GaAs layer 32 and the In_{y}Ga_{1-y}As layer 33.

An n-type GaAs channel layer (an active layer) 34 grows on the In_{y}Ga_{1-y}As layer 33 at a temperature of 630 °C in a thickness of 3000 Å. In the GaAs channel layer 34, silicon is included as an impurity at an impurity concentration of 1.5 × 10¹⁷ cm⁻³. The layers ranging from the LTB GaAs layer 32 to the GaAs channel layer 34 grow in order according to the MBE method or the like.

A gate electrode 35 made of WSi is formed on the GaAs channel layer 34, a source electrode 36 and a drain electrode 37 respectively made of AuGe/Au are formed on the GaAs channel layer 34 placed at both sides of the gate electrode 35.

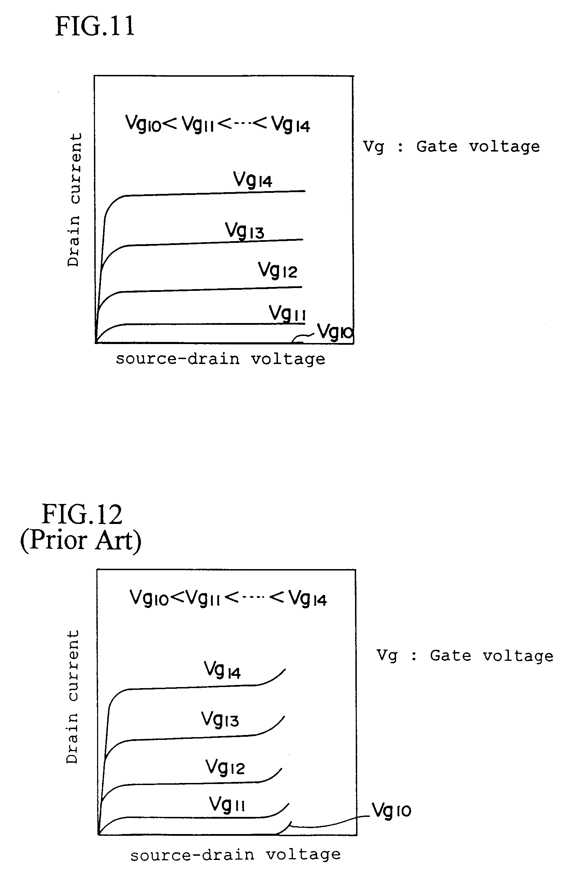

In the configuration described above, as shown in Fig. 11, a curved line indicating a relationship between a source-drain differential voltage and a drain current is saturated, and superior transistor characteristics are obtained. In contrast, in case of a MESFET in which an un-doped GaAs buffer layer, an n-type GaAs layer are formed in order on a silicon substrate without forming any LTB GaAs layer, a curved line indicating a relationship between a source-drain differential voltage and a drain current is not saturated as shown in Fig. 12, and it is realized that a spouting current flows.

Also, in the above MESFET according to this embodiment, the LTB GaAs layer 32 formed on the silicon substrate 31 has the high resistance, and the In_{y}Ga_{1-y}As layer 33 suppresses that the crystal defects in the LTB GaAs layer 32 diffuse to the channel layer 34, in the same manner as in the first embodiment. Therefore, a break-down voltage of the MESFET is improved, and characteristics such as a high frequency output power, a linearity, an efficiency and the like are improved.

### (A fourth embodiment)

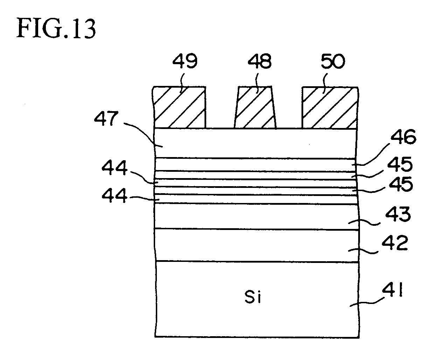

Fig. 13 is a cross sectional view showing a MESFET according to a fourth embodiment of the present invention.

In Fig. 13, an LTB GaAs layer 42 grows on an un-doped silicon substrate 41 at a temperature equal to or less than 200 °C in a film thickness of 2000 Å. In the LTB GaAs layer 42, a content of arsenic is higher than that of gallium.

A temperature absorbing GaAs layer 43 is formed on the LTB GaAs layer 42 at a thickness of 500 Å. The temperature absorbing GaAs layer 43 grows while a growing temperature is increased from a low temperature of 200 °C or less to a temperature of almost 540 °C. The arsenic excessively included in the LTB GaAs layer 42 precipitates to form coagulating grains under the influence of the growing temperature increased, and the LTB GaAs layer 42 has a high resistance.

A GaAs layer 44 and an In_{y}Ga_{1-y}As distorted layer 45 alternately grow on the temperature absorbing GaAs layer 43 to form a plurality of alternated layers. Each of the GaAs layers 44 and the In_{y}Ga_{1-y}As distorted layers 45 has a thickness of 50 Å. As a result, a supper lattice structure is formed with those layers 44 and 45. The layers 44, 45, for example, grow at a temperature of 538 °C. Here, it is preferred that a composition ratio y in the In_{y}Ga_{1-y}As be equal to or more than 0.2. The compound semiconductor layers described above grow in an un-doped condition.

Thereafter, an un-doped or p-type GaAs layer 46 is formed on the In_{y}Ga_{1-y}As distorted layer 45 placed at the top at a temperature of about 600 °C in a thickness of about 100 Å, and an n-type GaAs channel layer (an active layer) 47 having a silicon concentration of 1.5 × 10¹⁷ cm⁻³ is formed at a thickness of 1500 Å on the layer 46. The layers ranging from the LTB GaAs layer 42 to the GaAs channel layer 47 grow in order according to the MBE method or the like. A buffer layer is composed of the layers ranging from the LTB GaAs layer 42 to the GaAs layer 46.

Thereafter, a gate electrode 48 made of WSi is formed on the GaAs channel layer 47, and a source electrode 49 and a drain electrode 50 respectively made of AuGe/Au are formed on the GaAs channel layer 47 placed at both sides of the gate electrode 48.

In the above steps, the MESFET is constructed.

In the above configuration, a curved line indicating a relationship between a source-drain differential voltage and a drain current is saturated, and superior transistor characteristics are obtained. Also, the LTB GaAs layer 42 formed on the silicon substrate 41 has the high resistance, and the In_{y}Ga_{1-y}As layer 45 suppresses that the crystal defects in the LTB GaAs layer 42 diffuse to the channel layer 47, in the same manner as in the first embodiment. Therefore, a break-down voltage in the MESFET is improved, and characteristics such as a high frequency output power, a linearity, an efficiency and the like are improved.

This embodiment differs from the third embodiment in that the GaAs layer 44 and the In_{y}Ga_{1-y}As distorted layer 45 are alternately arranged to form a plurality of alternated layers, that is, a supper lattice structure. Therefore, the diffusion of the arsenic to the active layer is considerably suppressed in compared with that in case where a single In_{y}Ga_{1-y}As distorted layer is only arranged. The reason is that the arsenic is captured in each of the boundary faces respectively placed between one of the GaAs layers 44 and one of the In_{y}Ga_{1-y}As distorted layers 45.

### (Other embodiments)

It is applicable that the GaAs layer excessively having the arsenic and formed on the substrate be made to lattice-match with the InGaAs layer, a plurality of lattice-matching layers be formed, and the GaAs layer and the In_{y}Ga_{1-y}As layer be alternately arranged on the lattice-matching layers to for a plurality of alternated layers.

Also, the electronic device formed on the silicon substrate through the LTB GaAs layer is not limited to the MESFET, and it is applicable that the electronic device correspond to the HEMT.

As is described above, according to the present invention, on a first buffer layer comprising GaAs in which a content of As is higher than that of Ga, a second buffer layer comprising a compound semiconductor including In is formed, and an active layer is formed on the second buffer layer. Therefore, the amount of the arsenic diffused from the first buffer layer is reduced and the high frequency characteristics of the electronic device such as a high frequency output, a linearity, an efficiency and the like can be improved.

Arsenic diffused from the first buffer layer forms trap levels ranging from 0.3 to 0.4 eV in the active layer. When the second buffer layer is formed on the first buffer layer, the trap levels ranging from 0.3 to 0.4 eV in the active layer are reduced.

In cases where the first buffer layer comprises GaAs and InGaAs is used as a material of the second buffer layer, the trap levels can be moreover reduced when an Indium composition ratio is set to be equal to or more than 0.3. Also, in case where a film thickness of the InGaAs is set to be equal to or less than 100 Å, the crystal defects can have difficulty in being generated.

Also, in case where the InGaAs layer and the GaAs layer are alternately formed on the GaAs layer excessively having As, the trap levels ranging from 0.3 to 0.4 eV can be moreover reduced.

A substrate on which the GaAs layer excessively having As is formed is not limited to GaAs, and it is applicable that silicon be adopted as the substrate. A heat dissipation effect in the silicon substrate is superior to that in the GaAs. Even though the substrate is formed of silicon, a high resistance layer is obtained by the GaAs layer excessively having the arsenic on the silicon substrate. Therefore, the degradation of the break-down voltage can be suppressed. As a result, the high frequency characteristics can be improved.

## Claims

1. A compound semiconductor device, comprising:
a substrate (1);
a first buffer layer (2), formed on the substrate (1), comprising gallium arsenide in which arsenic is excessively included;
a second buffer layer (4,5), formed on the first buffer layer (2), comprising a compound semiconductor in which indium is included; and
an active layer (7) formed on the second buffer layer.

2. A compound semiconductor device according to claim 1, wherein the second buffer layer (5) is an indium-gallium-arsenic layer.

3. A compound semiconductor device according to claim 2, wherein a molar ratio of the indium included in the indium-gallium-arsenic layer (5) to the gallium included in the indium-gallium-arsenic layer (5) is equal to or more than 0.2.

4. A compound semiconductor device according to claim 2, wherein the indium-gallium-arsenic layer (5) has a thickness equal to or less than its critical ilm thickness.

5. A compound semiconductor device according to claim 1, wherein a film thickness of the first buffer layer (2) is substantially equal to 2000 Å.

6. A compound semiconductor device according to claim 1, wherein the second buffer layer has a superlattice structure in which an indium-gallium-arsenic layer (5) and a gallium arsenide layer (4) are alternately laminated.

7. A compound semiconductor device according to claim 6, wherein each of the indium-gallium-arsenic layers (5) and the gallium arsenide layers (4) has a film thickness substantially equal to or less than 100 Å.

8. A compound semiconductor device according to claim 1, wherein the substrate (1) is made of GaAs.

9. A compound semiconductor device according to claim 1, wherein the substrate (1) is made of silicon.

10. A compound semiconductor device according to claim 1, further comprising:
a third GaAs layer, formed between the first (2) and second (4,5) buffer layers, substantially having a thickness of 500 Å.

11. A compound semiconductor device according to claim 1, further comprising:
a fourth GaAs layer (6), formed between the second buffer layer (4,5) and the active layer (7), substantially having a film thickness of 100 Å.

12. A compound semiconductor device according to claim 1, wherein the active layer (7) has a two-dimensional electron gas channel region to form a field effect transistor.

13. A compound semiconductor device according to claim 12, wherein a gate electrode (8), a source electrode (9) and a drain electrode (10) are formed on the active layer (7) to form a field effect transistor.

14. A manufacturing method of a compound semiconductor device, comprising the steps of:
forming a first GaAs layer (2) excessively including arsenic at a growing temperature substantially equal to or less than 300 °C on a semiconductor substrate(1);
forming a second GaAs layer (3) on the first GaAs layer (2) by successively increasing a growing temperature up to 500 °C;
forming a group III-V compound semiconductor layer (4,5) including In on the second GaAs layer (3) at a growing temperature equal to or more than 500 °C; and
forming an active layer (6) on the group III-V compound semiconductor layer (4,5) as a transistor region.

15. A manufacturing method of a compound semiconductor device according to claim 14, further comprising the step of:
forming a third GaAs layer (6) between the group III-V compound semiconductor layer (4,5) and the active layer (7) at a growing temperature equal to or more than 600 °C in a thickness of substantially 100 Å.

16. A manufacturing method of a compound semiconductor device according to claim 14, wherein a material of the semiconductor substrate (1) is GaAs.

17. A manufacturing method of a compound semiconductor device according to claim 14, wherein a material of the semiconductor substrate (1) is silicon.

18. A manufacturing method of a compound semiconductor device according to claim 14, wherein the first GaAs layer (2) is formed to have a layer thickness of substantially 2000 Å.

19. A manufacturing method of a compound semiconductor device according to claim 14, wherein the second GaAs layer (2) is formed to have a layer thickness of substantially 500 Å.

20. A manufacturing method of a compound semiconductor device according to claim 14, wherein a material of the group III-V compound semiconductor layer (5) including In is InGaAs.

21. A manufacturing method of a compound semiconductor device according to claim 14, wherein said first GaAs layer (2) is formed by a molecular beam epitaxy, in which a radiation amount of arsenic is about five times as much as that of gallium in mole fraction.
